# EUROPEAN PATENT APPLICATION

(11) **EP 2 051 266 A2**
(43) Date of publication of application: **22.04.2009**
(21) Application number: 08155928.8
(22) Date of filing: 08.05.2008
(51) Int. Cl.: H01G 9/20

(54) **Dye-sensitized solar cell and method of fabricating the same**

(30) Priority: 18.10.2007 KR 20070104921
(71) Applicant: Electronics and Telecommunications Research Institute, Yuseong-gu, Daejeon 305-700 (KR)
(72) Inventor: Yun, Ho-Gyeong, Seoul (KR); Jun, Yong-Seok, Daejeon (KR); Kang, Man-Gu, Daejeon (KR); Lee, Seung-Yup, Kyungsangpukdo (KR); Pak, Hun-Kyun, Daejeon (KR); Park, Jong-Hyeok, Daejeon (KR); Kim, Jong-Dae, Daejeon (KR)
(74) Representative: Betten & Resch

(57) **Abstract**

Provided are a dye-sensitized solar cell and a method of fabricating the same. The dye-sensitized solar cell includes a lower substrate and an upper substrate separated from each other, a semiconductor electrode layer on the lower substrate, a dye layer adsorbed onto a surface of the semiconductor electrode layer, and an electrolyte between the lower and upper substrates. Here, an upper surface of the lower substrate adjacent to the semiconductor electrode layer includes at least one recess for increasing a contact area between the semiconductor electrode layer and the lower substrate.

## Description

### CROSS-REFERENCE TO RELATED APPLICATIONS

This patent application claims priority of Korean Patent Application No. 10-2007-104921, filed on October 18, 2007, the entire contents of which are hereby incorporated by reference.

### BACKGROUND OF THE INVENTION

The present invention disclosed herein relates to a dye-sensitized solar cell and a method of fabricating the same.

The present invention has been derived from research undertaken as a part of the information technology (IT) development business by Ministry of Information and Communication and Institute for Information Technology Advancement in the Republic of Korea (Project management No.: 2006-S-006-02, Project title: component module for ubiquitous terminal).

A solar cell is a photovoltaic energy conversion system that converts light energy radiated from the sun into electrical energy. A p-n junction diode formed in silicon is used for a commonly used silicon solar cell for the photovoltaic energy conversion. In order to prevent premature recombination of electrons and holes, the silicon with the high purity and low defect is required. Because such a requirement leads to an increase in the material cost, the silicon solar cell needs high fabrication cost per electrical power.

In addition, since only photons having energy higher than bandgap contribute to creating a current, the silicon of the silicon solar cell is doped so as to have a bandgap as low as possible. However, because of the low band gap, electrons excited by blue light or UV have excessive energy, and are wasted as heat rather than to contribute to creating a current. Also, in order to increase the chance of capturing photons, a p-type layer needs to be sufficiently thick. However, since such a thick p-type layer increases the chance that the exited electrons are recombined with holes before reaching the p-n junction, the efficiency of the silicon solar cell ranges from about 7% to about 15% at most.

Meanwhile, Michael Gratzel, Mohammad K. Nazeeruddin, Brian O'Regan invented a dye-sensitized solar cell (DSSC), which is also known as a Gratzel cell, based on the photosynthetic reaction in 1991 (Refer to U.S. Patent No. 4,927,721 and U.S. Patent No. 5,350,644). The dye-sensitized solar cell, of which prototype is the Gratzel cell, is a photoelectrochemical system that uses dyes and a transition metal oxide layer, not a p-n junction diode, for the photovoltaic energy conversion. The dye-sensitized solar cell is formed of an inexpensive material and prepared through a simple fabrication method, reducing the fabrication cost compared with the silicon solar cell. In addition, the dye-sensitized solar cell has the energy conversion efficiency similar to that of the silicon solar cell, and thus needs the low fabrication cost per electrical power. Therefore, it is expected that the dye-sensitized solar cell can be commercialized soon, if the technology for increasing the energy conversion efficiency and power is developed.

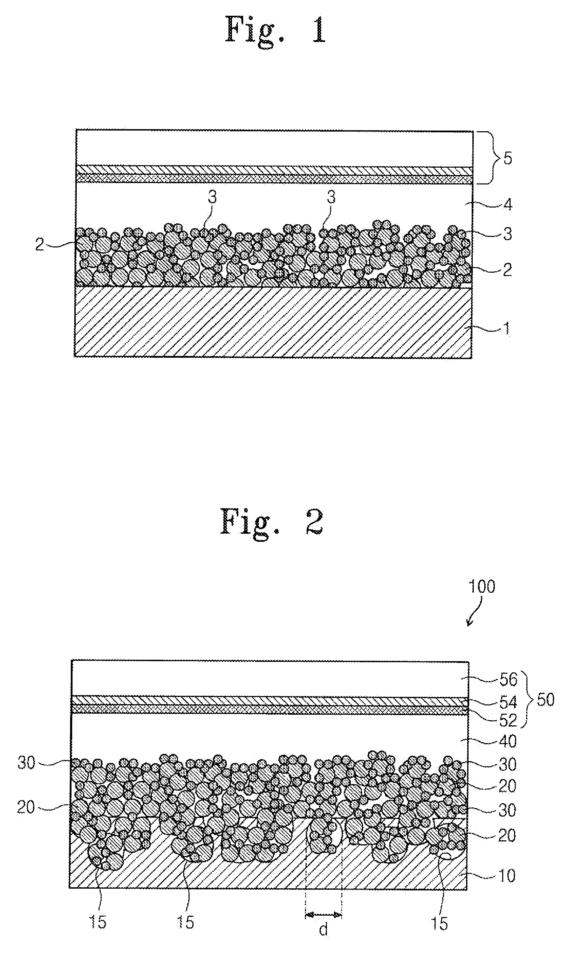

FIG. 1 is a cross-sectional view of a typical dye-sensitized solar cell.

Referring to FIG. 1, the dye-sensitized solar cell includes a lower substrate 1 having conductivity, oxide semiconductor particles 2 stacked on the lower substrate 1, dye molecules 3 adsorbed onto surfaces of the oxide semiconductor particles 2, an upper substrate structure 5 separated from and facing the lower substrate 1, and an electrolyte 4 between the lower substrate 1 and the upper substrate structure 5. When the sunlight is radiated, electrons of the dye molecules 3 are excited by the light energy, and injected into the conduction band of the oxide semiconductor particles 2. Thereafter, the electrons pass through the lower substrate 1, a predetermined load (not shown), and the upper substrate structure 5, and are reduced in the electrolyte 4. Such a process is called by an electron circulation of the dye-sensitized solar cell.

Meanwhile, in the case of the typical dye-sensitized solar cell, since the oxide semiconductor particles 2 and the lower substrate 1 are in contact with the electrolyte 4, some of electrons may not participate in operating the load but directly injected into the electrolyte 4 from the lower substrate 1. The separation of electrons from the electron circulation of the dye-sensitized solar cell causes decrease in the energy conversion efficiency and electrical power of the dye-sensitized solar cell. Therefore, it is necessary to reduce the number of the electrons separated from the electron circulation.

### SUMMARY OF THE INVENTION

The present invention provides a dye-sensitized solar cell having the improved energy conversion efficiency.

The present invention also provides a method of fabricating a dye-sensitized solar cell having the improved energy conversion efficiency.

Embodiments of the present invention provide dye-sensitized solar cells including a lower substrate where at least one recess is formed. In more detail, the dye-sensitized solar cells include: a lower substrate and an upper substrate separated from each other; a semiconductor electrode layer on the lower substrate; a dye layer adsorbed onto a surface of the semiconductor electrode layer; and an electrolyte between the lower and upper substrates. An upper surface of the lower substrate adjacent to the semiconductor electrode layer includes at least one recess that allows a contact area between the semiconductor electrode layer and the lower substrate to be increased.

In some embodiments, the lower substrate includes at least one of metals and metal alloys or glass. Also, the semiconductor electrode layer includes a plurality of oxide semiconductor particles, and the size of the recess is larger than at least a diameter of the oxide semiconductor particles. However, it is clear that technical effects of increasing a contact area between the semiconductor electrode layer and the lower substrate can be obtained even in the case tat the recess is smaller than a diameter of the oxide semiconductor particles.

In other embodiments of the present invention, methods of fabricating dye-sensitized solar cells include forming at least one recess in a lower substrate. The methods include: forming at least one recess in an upper surface of a lower substrate; forming a semiconductor electrode layer on the lower substrate including at least one recess; adsorbing a dye layer onto a surface of the semiconductor electrode layer; disposing an upper substrate facing the lower substrate on the resulting structure including the dye layer; and injecting an electrolyte between the lower and upper substrates.

In some embodiments, the lower substrate is formed of at least one of metals and metal alloys. Also, the forming of at least one recess in the upper surface of the lower substrate includes treating the upper surface of the lower substrate with chemicals that chemically reacts with the lower substrate. In more detail, the forming of at least one recess in the upper surface of the lower substrate includes eroding the upper surface of the lower substrate with an acid solution using a chemical or electrochemical method. The electrochemical method includes applying a voltage to the acid solution.

In other embodiments, the method of the fabricating dye-sensitized solar cells further include, before the forming of the semiconductor electrode layer, forming a blocking layer on the upper surface of the lower substrate including at least one recess. The forming of the blocking layer includes coating the upper surface of the lower substrate including at least one recess with the blocking layer using at least one of electrophoresis, electroplating, spin-coating, and dip-coating. For example, the forming of the blocking layer includes: coating the upper surface of the lower substrate including at least one recess with metal or metal precursor; and oxidizing the coated metal or metal precursor using anodizing or thermal oxidization.

### BRIEF DESCRIPTION OF THE FIGURES

The accompanying figures are included to provide a further understanding of the present invention, and are incorporated in and constitute a part of this specification. The drawings illustrate exemplary embodiments of the present invention and, together with the description, serve to explain principles of the present invention. In the figures:

FIG. 1 is a cross-sectional view of a typical dye-sensitized solar cell;

FIG. 2 is a cross-sectional view of a dye-sensitized solar cell according to an embodiment of the present invention;

FIG. 3 is a cross-sectional view of a dye-sensitized solar cell according to another embodiment of the present invention;

FIG. 4 is a flowchart illustrating a method of fabricating a dye-sensitized solar cell according to an embodiment of the present invention;

FIG. 5 is a flowchart illustrating a method of fabricating a dye-sensitized solar cell according to another embodiment of the present invention; and

FIG. 6 is a current versus voltage graph showing the enhanced efficiency characteristic of a dye-sensitized solar cell according to the present invention.

### DETAILED DESCRIPTION OF PREFERRED EMBODIMENTS

Preferred embodiments of the present invention will be described below in more detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art.

Preferred embodiments of the present invention will be described below in more detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art.

It will also be understood that when a layer is referred to as being on another layer or substrate, it can be directly on the other layer or substrate, or intervening layers may also be present. Also, though terms like a first, a second, a third, or the like are used to describe various regions, layers, or the like in various embodiments of the present invention, the regions, layers, or the like are not limited to these terms. These terms are used only to differentiate one region or layer from another one. Therefore, a layer referred to as a first layer in an embodiment can be referred to as a second layer in another embodiment. Each embodiment described and illustrated here also includes its complementary embodiments.

FIG. 2 is a cross-sectional view of a dye-sensitized solar cell according to an embodiment of the present invention.

Referring to FIG. 2, a dye-sensitized solar cell 100 includes a lower substrate 10, an upper substrate structure 50 separated from and facing the lower substrate 10, and a semiconductor electrode layer. The semiconductor electrode layer is disposed between the lower substrate 10 and the upper substrate structure 50 and attached to the lower substrate 10. An electrolyte 40 is disposed between the lower substrate 10 and the upper substrate structure 50, and a dye layer 30 is adsorbed onto a surface of the semiconductor electrode layer.

The lower substrate 10 may include at least one of conductive materials. For example, the lower substrate 10 may include at least one of metals and metal alloys, and in this case, the lower substrate 10 may be formed in the shape of a thin layer or a foil. The lower substrate 10 may include glass coated with a conductive layer or a polymer film coated with a conductive layer.

According to the present invention, an upper surface of the lower substrate 10 that is in contact with the semiconductor electrode layer includes at least one recess 15. The recess 15 may have a diameter d ranging from several nm to several tens of um. Meanwhile, according to an embodiment of the present invention, recesses 15 may be formed in the entire upper surface of the lower substrate 10 with a uniform density. Here, the density of the recesses 15 may be defined as the number of the recesses 15 per a unit area. However, though the recesses 15 have the uniform density, they may not be formed regularly. That is, the recesses 15 may be uniform in density globally, though they locally differ in density. As a result, the upper surface of the lower substrate 10 may have a porous structure capable of increasing its surface area. Meanwhile, the surface area of the upper surface of the lower substrate 10 may be increased through various methods. For example, the upper surface of the lower substrate 10 may have various structures capable of increasing its surface area, such as a tube, wire, a brush, fur, a rod, a branch.

The semiconductor electrode layer may include semiconductor particles 20. The semiconductor electrode layer may be formed of one of metal oxides including transition metal oxide. For example, the semiconductor particles 20 may include one of titanium oxide (TiO₂), tin oxide (SnO₂), zirconium oxide (ZrO₂), silicon oxide (SiO₂), magnesium oxide (MgO), niobium oxide (Nb₂O₅), and zinc oxide (ZnO).

The semiconductor particles 20 may include, as illustrated in FIG. 2, semiconductor particles attached to the surface of the lower substrate 10 having the recesses 15 and semiconductor particles stacked thereon. That is, the semiconductor particles forming the semiconductor electrode layer may have a multilayer structure. According to the present invention, the semiconductor particles 20 may have the size smaller than the recesses 15 so as to be disposed inside the recesses 15. For example, each of the semiconductor particles 20 may have the size ranging from approximately several nanometers to several tens of nanometers. Therefore, the plurality of semiconductor particles 20 may be disposed inside one recess 15.

The increased surface area of the lower substrate 10 increases the contact area between the lower substrate 10 and the semiconductor electrode layer to improve the junction characteristic therebetween. In addition, as described above, when the semiconductor particles 20 are disposed inside the recess 15, a traveling path of electrons is shortened, thereby improving the efficiency of the dye-sensitized solar cell 100.

The dye layer 30 includes dye molecules that can convert light energy into electrical energy. The dye layer 30 may include ruthenium complex. For example, the dye layer 30 may include N719 (Ru(dcbpy)2(NCS2) containing 2 protons), However, the dye-sensitized solar cell 100 may include at least one of various dyes such as N712, Z907, Z910, and K19.

The electrolyte 40 may include a redox iodide electrolyte. According to an embodiment of the present invention, the electrolyte 40 may include an I₃/r electrolyte made by resolving 0.7 M of 1-vinyol-3-hexyl-imidazolium iodide, 0.1 M of LiI, and 40 mM of 12(iodine) with 3-Methoxypropionitrile. According to another embodiment of the present invention, the electrolyte 40 may include an acetonitrile solution containing 0.6 M of butylmethylimidazolium, 0.02 M of 12, 0.1 M of Guanidinium thiocyanate, and 0.5 M of 4-tert-butylpyridine. However, one of various electrolytes may be used for the dye-sensitized solar cell according to the present invention. For example, the electrolyte 40 may contain alkylimidazolium iodides or tetra-alkylammoniumiodides, and further contain tert-butylpyridin (TBP), benzimidazole (BI), and N-Methylbenzimidazole (NMB1) as surface additives. Also, acetonitrile, propionitrile, or mixed liquid of valeronitrile and acetonitrile may be used as a solvent.

The upper substrate structure 50 includes an upper transparent substrate 56 and an upper electrode layer 54 coated on one surface of the upper transparent substrate 56. Here, the upper substrate structure 50 is disposed such that the upper electrode layer 54 faces the lower substrate 10. The upper electrode layer 54 may be formed of at least one of ITO, FTO, ATO, SnO₂, ZnO, and a carbon nanotube. The upper substrate structure 50 may further include a catalyst layer 52 that is disposed on the upper electrode layer 54 and in contact with the electrolyte 40. The catalyst layer 52 accelerates resolution of triiodide into iodide. According to an embodiment of the present invention, the catalyst layer 52 may include platinum (Pt) coated on the upper electrode layer 54 with an amount ranging from about 5 µg/cm² to about 10 *µ*g/cm².

Meanwhile, excited electrons transferred to the lower substrate 10 through the semiconductor electrode layer are transferred to the dye molecules through the upper electrode layer 54 and the electrolyte 40. The dye-sensitized solar cell continuously creates a current through the electron circulation. For the electron circulation, the upper electrode layer 54 may be connected to the lower substrate 10 through a predetermined interconnection structure (not shown), and a load (not shown) consuming energy of the electrons may be placed on the predetermined interconnection structure.

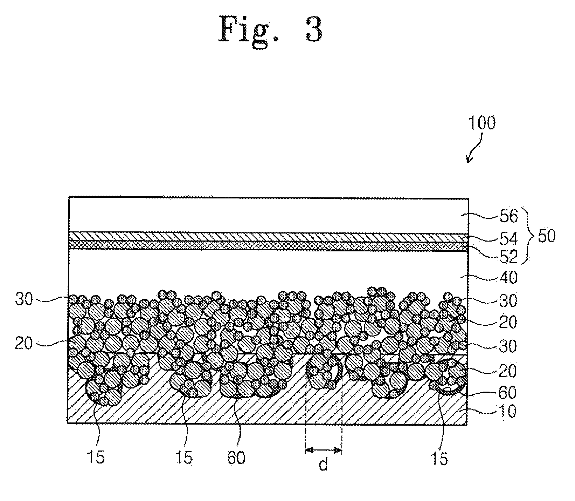

FIG. 3 is a cross-sectional view of a dye-sensitized solar cell 110 according to another embodiment of the present invention. Since the embodiment of FIG. 3 is similar to the embodiment of FIG. 2 except that the dye-sensitized solar cell 110 further includes a blocking layer, duplicate description will not be given herein for the sake of descriptive simplicity.

Referring to FIG. 3, a blocking layer 60 may cover the upper surface of the lower substrate 10. Here, the blocking layer 60 may cover inner walls of the recesses 15 that are formed on the upper surface of the lower substrate 10. As a result, the blocking layer 60 may be disposed between the lower substrate 10 and the semiconductor electrode layer. This prevents the lower substrate 10 from directly being in contact with the electrolyte 40, thus reducing the number of electrons directly injected from the lower substrate 10 into the electrolyte 40, and preventing recombination of electrons and holes. Accordingly, the photovoltaic conversion efficiency of the dye-sensitized solar cell 100 according to this embodiment can increase compared with the embodiment of FIG. 1. In addition, the blocking layer 60 improves the adhesive characteristic between the semiconductor electrode layer and the lower substrate 10.

Meanwhile, in order to maximize the above-effects, the blocking layer 60 may have a uniform thickness to cover the upper surface of the lower substrate 10. According to an embodiment of the present invention, the blocking layer 60 may include oxide semiconductor particles having the size smaller than the semiconductor particles forming the semiconductor electrode layer. Any known oxide semiconductor material may be used for the blocking layer 60. Preferably, the blocking layer 60 may include at least one of metal oxides such as titanium oxide (TiO₂), tin oxide (SnO₂), zirconium oxide (ZrO₂), silicon oxide (SiO₂), magnesium oxide (MgO), niobium oxide (Nb₂O₅), and zinc oxide (ZnO). Additionally, the blocking layer 60 may be formed by oxidizing a metal such as Ti, Sn, Zr, Si, Mg, Nb, and Zn or a precursor thereof.

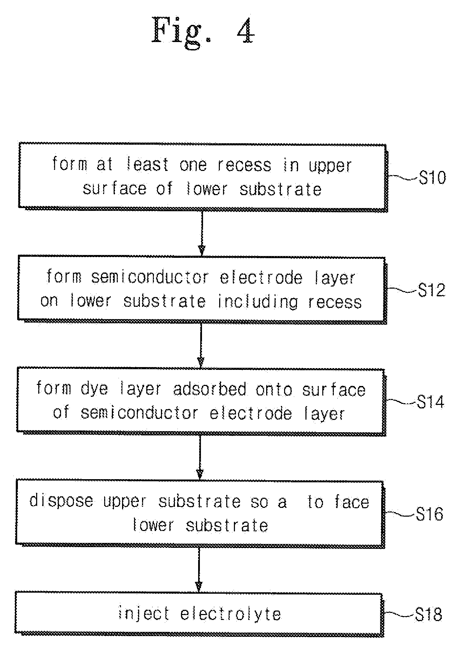

FIG. 4 is a flowchart illustrating a method of fabricating a dye-sensitized solar cell according to an embodiment of the present invention.

Referring to FIG. 4, at least one recess 15 is formed in an upper surface of a lower substrate 10 (S10). The lower substrate 10 may have the shape of a thin layer or a foil, which includes at least one of conductive materials such as metal and metal alloys. Alternatively, the lower substrate 10 may include a glass or a polymer film coated with a conductor.

The recess 15 may be formed by treating the lower substrate 10 with chemicals capable of reacting with the lower substrate 10. For example, if the lower substrate 10 is formed of metal or metal alloys, the recess 15 may be formed by chemically eroding a surface of the lower substrate 10 using a predetermined acid solution or applying a predetermined voltage to an acid solution to electrochemically erode a surface of the lower substrate 10. In this case, process conditions such as the treatment time, a treatment temperature, the kind and concentration of used acids/additives, the applied current density, or the like may be controlled so as to control the surface roughness of the lower substrate 10. According to an embodiment of the present invention, the lower substrate 10 may be formed of stainless steel. Here, the surface of the lower substrate 10 may have a porous structure including the recess 15 using an aqueous solution containing about 0.1M to several M of acid, in the case of the chemical treatment. Alternatively, an aqueous solution containing about 0.01% to several % of acid by volume may be used in the electrochemical treatment.

According to a modified embodiment of the present invention, the surface of the lower substrate 10 may be treated by using at least one of mechanical and physical ways to form the recess 15. For instance, the mechanical way may use a mechanical tools to form scratches on the surface of the lower substrate 10, and the physical ways may use a laser beam or a plasma to form scratches on the surface of the lower substrate 10.

Next, a semiconductor electrode layer is formed on the lower substrate 10 including the recess 15 (S12). The semiconductor electrode layer may be formed of one of metal oxides including transition metal oxide. For example, the semiconductor electrode layer may be formed of one of titanium oxide (TiO₂), tin oxide (SnO₂), zirconium oxide (ZrO₂), silicon oxide (SiO₂), magnesium oxide (MgO), niobium oxide (Nb₂O), and zinc oxide (ZnO).

According to an embodiment of the present invention, the semiconductor electrode layer may include titanium oxide particles having the size ranging from about 3 nm to about 30 nm, and be coated on the lower substrate 10 to a thickness ranging from about 5 mm to about 30 mm. Here, in forming the semiconductor electrode layer, viscous colloid having nanoparticles TiO₂ may be coated on the lower substrate 10, and then a predetermined heat treatment may be performed such that only the titanium oxide particles remain on the lower substrate 10. In detail, in preparing the viscous colloid having nanoparticles TiO₂, liquid TiO₂ colloid may be prepared, a solvent may be evaporated from the liquid TiO₂ colloid, and then at least one of polyethylene glycol and polyethylene oxide may be added. Here, the liquid TiO₂ may be obtained by hydrothermally synthesizing titanium isopropoxide and acetic acid in an autoclave maintained at about 220 °C. Also, the solvent is evaporated until TiO₂ content becomes about 10% to about 15% by weight, and resultantly nanoparticles TiO₂ forming the semiconductor electrode layer are created in the liquid TiO₂ colloid through the above-processes. The polyethylene glycol and the polyethylene oxide may be added such that the nanoparticles TiO₂ have viscosity, and the added polyethylene glycol and polyethylene oxide may be removed through the heat treatment. The heat treatment may be performed under the temperature condition ranging from about 450 °C to about 550 °C As a result, the titanium oxide particles remain on the lower substrate 10.

A dye layer 30 containing dye molecules is formed on a surface of the semiconductor electrode layer (S14). In forming the dye layer 30, the lower substrate 10 including the semiconductor electrode layer is immersed in an alcohol solution containing a dye for about 24 hours. Thereafter, the lower substrate 10 may be taken out from the alcohol solution, and washed with alcohol. Here, the dye may include ruthenium complex. For example, the dye may include N719 (Ru(dcbpy)2(NCS)2 containing 2 protons). However, at least one of known dyes such as N712, Z907, Z910, and K19 may be used for the dye-sensitized solar cell according to the present invention.

An upper substrate structure 50 is disposed over the lower substrate 10 so as to face the lower substrate 10. The upper substrate structure 50 includes an upper substrate 56 and an upper electrode layer 54 coated on one surface of the upper substrate 56. The upper substrate 56 may be formed of a glass or a flexible material. The flexible material may include, as described above, at least one of metal materials such as stainless steel or aluminum. The upper electrode layer 54 may be formed of at least one of ITO, SnO₂, FTO, ZnO, and a carbon nanotube. In addition, a catalyst layer 52 may be formed on the upper electrode layer 54. According to an embodiment, the catalyst layer 52 may include platinum coated on the upper electrode layer 54 with an amount ranging from about 5 µg/cm² to about 10 µg/cm².

Meanwhile, the upper substrate structure 50 is attached to the lower substrate 10. In the attachment, after a predetermined polymer layer (not shown) is formed between the lower substrate 10 and the upper substrate structure 50, the lower and upper substrates 10 and 56 may be pressed together under condition that a pressure ranges from about 1 Pa to about 3 Pa and a temperature ranges from about 100 °C to about 140 °C. Here, the polymer layer may include a material named SURLYN, sold by DuPont.

An electrolyte is injected between the lower substrate 10 and the upper substrate structure 50 through a predetermined injection hole (not shown) (S18). The electrolyte may be a redox iodide electrolyte. According to an embodiment of the present invention, the electrolyte may be acetonitrile including 0.6M butylmethylimidazolium, 0.02 M 12, 0.1 M guanidinium thiocyanate, 0.5 M 4-tert-butylpyridine. However, one of various other electrolytes not exemplarily described may be used for a dye-sensitized solar cell of the present invention. For example, the electrolyte may further include alkylimidazolium iodides or tetra-alkyl ammoniumiodides, surface additives including tert-butylpyridin (TBP), benzimidazole (BI), and N-Methylbenzimidazole (NMBI). Acetonitrile, propionitrile, or a mixed liquid of valeronitrile and acetonitrile is used as a solvent.

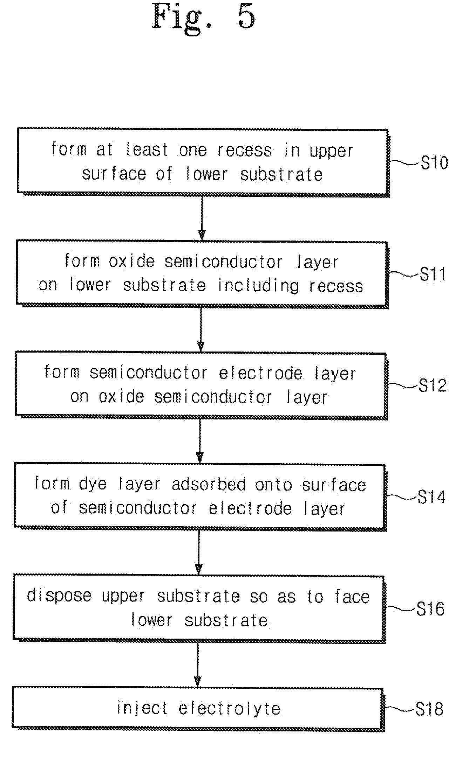

FIG. 5 is a flowchart illustrating a method of fabricating a dye-sensitized solar cell according to another embodiment of the present invention. Since the embodiment of FIG. 5 is similar to the embodiment of FIG. 4 except that forming of a blocking layer is further included, duplicated description will be ommitted herein for the sake of descriptive simplicity.

Referring to FIG. 5, before forming the semiconductor electrode layer, a blocking layer 60 is formed on the lower substrate 10 (S11). According to this embodiment of the present invention, the blocking layer 60 is conformally formed so as to cover inner walls of recesses 15 formed in an upper surface of the lower substrate 10.

The blocking layer 60 may be formed using one of electrophoresis, electroplating, spin-coating, dip-coating, and the like. Here, because the lower substrate 10 formed of a conductive material is used as an electrode in the electrophoresis or the electroplating, the blocking layer 60 can be formed to a uniform thickness. Therefore, when it is required that the blocking layer 60 should be conformally formed on inner walls of the recesses 15, the electrophoresis or the electroplating is preferably employed.

In more detail, the electrophoresis is a method of coating the lower substrate 10 with an oxide semiconductor using an electrophoretic phenomenon that particles included in a solution move toward an electrode to which a DC voltage is applied. The blocking laver 60 can be directly formed on the lower substrate 10 through the electrophoresis. Most of oxide semiconductor such as TiO₂, SnO₂, ZnO, and MgO may be formed using the electrophoresis.

In the electroplating, a metal layer is formed on the lower substrate 10 by reducing metal ions contained in the electrolyte. In this case, the metal layer is oxidized through the foregoing thermal oxidization or anodizing to form the blocking layer 60. The electroplating may be applied to most metals, most noble metals, and precursors thereof.

Thereafter, forming of a semiconductor electrode layer (S12) through injecting of the electrolyte (S18) may be performed in the same manner as the embodiment of FIG. 4.

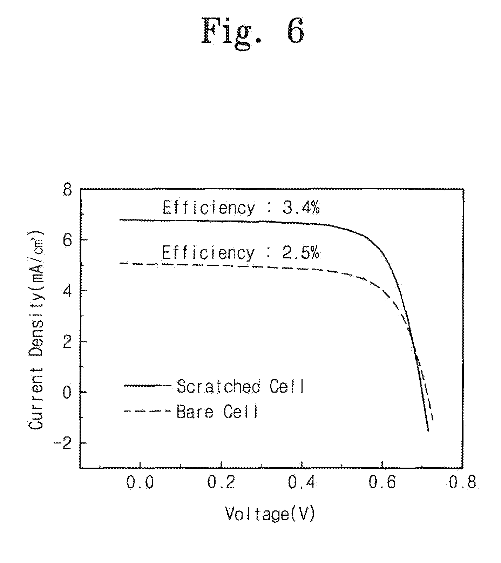

FIG. 6 is a current versus voltage graph showing the enhanced efficiency characteristic of a dye-sensitized solar cell according to the present invention. A dye-sensitized solar cell including a flat lower substrate fabricated through a typical method and the dye-sensitized solar cell including the lower substrate 10 having the porous structure fabricated through the method of present invention are used in this experiment for the comparison. The two compared dye-sensitized solar cells have the same structure except the structural difference in the upper surface of the lower substrate 10.

In the experiment, a xenon lamp (Oriel, 91193) is used as a light source. In the graph of FIG. 6, a photovoltage and a photocurrent respectively represented in a horizontal axis and a vertical axis are obtained by correcting a solar condition of the xenon lamp using a standard solar cell.

Referring to FIG. 6, it is measured that the dye-sensitized solar cell, which is a scratched cell indicated by a solid line has the photovoltaic conversion efficiency of 3.4%. On the other hand, it is measured that the typical dye-sensitized solar cell, which is a bare cell indicated by a dotted line has the photovoltaic conversion efficiency of 2.5%. That is, the dye-sensitized solar cell according to the present invention has the photovoltaic conversion efficiency improved as much as about 36% compared with the typical dye-sensitized solar cell. In this regard, it is shown that the efficiency of the dye-sensitized solar cell can be improved when the holes for increasing a surface area are formed in the lower substrate.

The above-disclosed subject matter is to be considered illustrative, and not restrictive, and the appended claims are intended to cover all such modifications, enhancements, and other embodiments, which fall within the true spirit and scope of the present invention. Thus, to the maximum extent allowed by law, the scope of the present invention is to be determined by the broadest permissible interpretation of the following claims and their equivalents, and shall not be restricted or limited by the foregoing detailed description.

## Claims

1. A dye-sensitized solar cell comprising:
a lower substrate and an upper substrate separated from each other;
a semiconductor electrode layer on the lower substrate;
a dye layer adsorbed onto a surface of the semiconductor electrode layer; and
an electrolyte between the lower and upper substrates,
wherein an upper surface of the lower substrate adjacent to the semiconductor electrode layer is formed to define at least one recess that increases a contact area between the semiconductor electrode layer and the lower substrate.

2. The dye-sensitized solar cell of claim 1, wherein the lower substrate includes at least one of metals, metal alloys, a glass coated with a conductive layer, and a polymer film coated with a conductive layer.

3. The dye-sensitized solar cell of any of the preceding claims, further comprising a blocking layer disposed between the lower substrate and the semiconductor electrode layer to cover an inner wall of the recess in the upper surface of the lower substrate.

4. The dye-sensitized solar cell of claim 3, wherein the blocking layer includes at least one of oxide semiconductor materials.

5. The dye-sensitized solar cell of any of the preceding claims, wherein the semiconductor electrode layer includes a plurality of oxide semiconductor particles, and the size of the recess is larger than at least a diameter of the oxide semiconductor particles.

6. A method of fabricating a dye-sensitized solar cell, comprising:
forming at least one recess in an upper surface of a lower substrate;
forming a semiconductor electrode layer on the lower substrate including at least one recess;
adsorbing a dye layer onto a surface of the semiconductor electrode layer;
disposing an upper substrate facing the lower substrate on the resulting structure including the dye layer; and
injecting an electrolyte between the lower and upper substrates.

7. The method of claim 6, wherein the lower substrate is formed of at least one of metals and metal alloys, and
the forming of at least one recess in the upper surface of the lower substrate comprises treating the upper surface of the lower substrate with chemicals.

8. The method of claim 7, wherein the forming of at least one recess in the upper surface of the lower substrate comprises eroding the upper surface of the lower substrate with an acid solution.

9. The method of any of claims 6 to 8, further comprising, before the forming of the semiconductor electrode layer, forming a blocking layer on the upper surface of the lower substrate including at least one recess.

10. The method of claim 9, wherein the forming of the blocking layer comprises coating the upper surface of the lower substrate including at least one recess with the blocking layer using at least one of electrophoresis and electroplating.

11. The method of claim 9, wherein the forming of the blocking layer comprises:
coating the upper surface of the lower substrate including at least one recess with metal or metal precursor; and
oxidizing the coated metal or metal precursor using anodizing or thermal oxidization to form the blocking layer.

12. The method of any of claims 6 to 11, wherein forming at least one recess comprises treating the upper surface of the lower substrate using at least one of mechanical and physical ways.
